# EUROPEAN PATENT SPECIFICATION

(11) **EP 0 358 504 B1**
(45) Date of publication and mention of the grant of the patent: **14.12.1994**
(21) Application number: 89309079.5
(22) Date of filing: 07.09.1989
(51) Int. Cl.: H01H 11/00

(54) **Electrical components**
Elektrische Komponente
Composants électriques

(30) Priority: 08.09.1988 GB 8821103
(43) Date of publication of application: 14.03.1990
(73) Proprietor: LUCAS INDUSTRIES public limited company, Birmingham, B19 2XF West Midlands (GB)
(72) Inventor: Heap,Alec John, Reedley Burnley Lancaster (GB)
(74) Representative: Carpenter, David

(56) References cited:
- EP-A- 0 304 112
- DE-U- 8 713 320
- FR-A- 2 592 522

## Description

This invention relates to an electrical circuit element comprising an electrically insulating substrate carrying electrical conductors, the element being for incorporation into an electrical component, particularly, but not exclusively, a sliding action electrical switch.

It is known to produce an electrical circuit element by securing, for example by rivetting or staking, preformed electrical conductors onto a substrate formed from an electrically insulating material. It is also known to produce printed circuits, both rigid printed circuit boards wherein conductor patterns are printed onto a rigid electrically insulating substrate, and flexible printed circuits wherein, as the name suggests, both the conductors and the substrate are flexible. It is also known to provide a plurality of preformed electrical conductors as a single stamping whereby the conductors in the form of a fret can be handled as a single unit, and are separated from one another, to isolate them electrically from one another, only after the fret has been attached to the substrate. Flexible printed circuits have a relatively low current carrying capability and so are not suitable for use in electrical components requiring high current. Preformed conductors are capable of carrying high currents but represent a serious material and space wastage in a low current environment.

It is an object of the present invention to provide an electrical, circuit wherein the aforementioned disadvantages are minimised and which is particularly suited for use inter alia as the fixed contact structure of a sliding action switch.

EP-A-0304112 published on 22-2-89 discloses a moulded resin component incorporating a flexible circuit element to the conductors of which are attached rigid pressed metal terminal pins which project from an end wall of the moulding. DE-U-8713320 shows an electrical switch having planar contacts and a resistance track supported on a planar insulating substrate. Neither of these references discloses an arrangement capable of meeting the objectives of the present invention.

In accordance with the present invention there is provided an electrical circuit element for use in an electrical component including a moulded synthetic resin substrate and two electrical conductor sets and individually supported on said substrate for engagement in use by a further relatively movable part of said electrical component, the element being characterized by a first of said conductor sets including at least one preformed metal strip, the second of said conductor sets including at least one printed track, and an upper edge of said at least one strip and said at least one printed track being exposed on said substrate flush with the surface thereof, for engagement in use by a further relatively movable, part of said electrical component.

The term "printed track" as used herein in relation to electrical conductors is intended to mean an electrical conductor produced by a printing technique, or any allied technique of the kind used in the production of both flexible and rigid printed circuits.

Desirably the strip and the track are accessible at one face of the substrate.

Preferably the moulded synthetic resin substrate is shaped to form a structural member of the electrical component utilizing the electrical circuit element.

Desirably said printed track includes an active electrical component.

In accordance with a second aspect of the present invention there is provided a method of manufacturing an electric circuit element comprising the steps of starting with mould means defining the shape of a desired substrate, positioning within said mould means at least one electrical conductor in the form of a preformed metallic strip, positioning within said mould means, in relation to said strip, a flexible printed circuit including a flexible, electrically insulating backing member with a flexible conductive track exposed on one face thereof, the positioning of the strip and the flexible printed circuit in said mould means being such that after moulding said strip and said track will be exposed on the moulded substrate, and, introducing synthetic resin material into said mould means to form said substrate.

Preferably said strip has additional strips integral therewith and the method includes the subsequent step of removing predetermined inter- connections between the strips to isolate some or all of the strips electrically from one another.

Preferably said flexible printed circuit includes at least one active electrical component.

Desirably said active electrical component is an elongate, printed resistor.

One example of the invention is illustrated in the accompanying drawings wherein:-
Figure 1 is a sectional view of an electrical switch having a sliding action and incorporating a variable resistor,
Figure 2 is a sectional view on the line 2-2 of Figure 1 with certain components thereof omitted for clarity,
Figure 3 is a plan view of a conductor fret for use in the manufacture of the switch illustrated in Figures 1 and 2, and
Figure 4 is a view similar to Figure 3 of a flexible printed circuit for use in the manufacture of the switch.

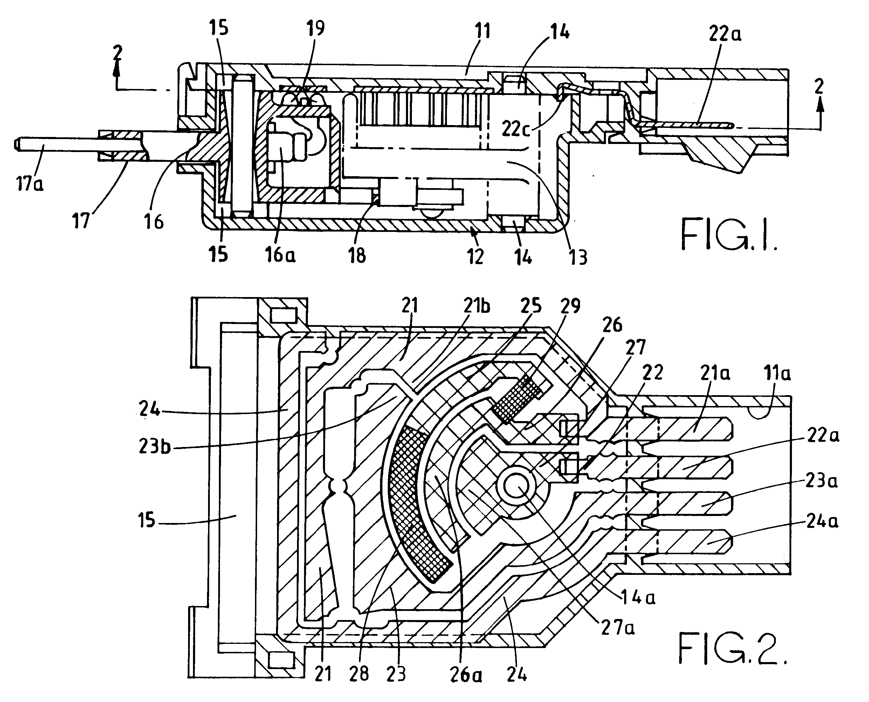

Referring to the drawings, the switch includes a two part moulded synthetic resin housing, the two parts being respectively a fixed contact carrier 11 and a cover 12. Although not of particular importance to an understanding of the present invention it can be seen from Figure 1 that the switch further includes a moulded synthetic resin rotor 13 having a pair of integral, axially aligned and oppositely directed spigots 14 which are received in corresponding apertures in the carrier 11 and cover 12 to mount the rotor for angular movement about the axis of the spigots 14 within the switch housing. The rotor 13 carries movable contacts which can cooperate with fixed contacts (to be described in more detail later) on the carrier 11.

Adjacent one end of the housing there is defined a rectilinearly extending channel 15 which guides an operating member 16 for rectilinear movement relative to the housing along the length of the channel. The operating member 16 is moulded in synthetic resin material and includes a portion 17 protruding from the housing for manual operation. Within the housing the operating member 16 is coupled by way of a yoke arrangement 18 to the rotor 13 so that rectilinear movement of the operating member 16 along the channel 15 causes angular movement of the rotor 13 about the axis of the spigots 14. The operating member 16 also carries a movable contact member 19 which cooperates with further fixed contacts on the carrier 11.

The carrier 11 and the conductors supported thereby constitute an electrical circuit element comprising a moulded synthetic substrate carrying, on its inner face, a plurality of exposed electrical conductors. The exposed surfaces of the conductors are flush with one another, and the conductors are inset into the surface of the synthetic resin material forming the carrier 11 so that the surface of the conductors is flush with the surface of the electrically insulating synthetic resin material between the conductors. Figure 2 illustrates the pattern of conductors and the mode of construction of the circuit element will be described below with reference to Figures 2, 3, and 4.

It can be seen that the conductors on the inner surface of the carrier 11 can be divided into two sets, one set being indicated in Figure 2 by diagonal hatching, and the other set being indicated by crossed hatching. In the example illustrated in the drawings the first set of conductors comprises four conductors and the second set comprises three conductors. It is to be understood however that a wide variety of different arrangements and numbers of conductors is within the scope of the invention. In Figure 2 the four conductors of the first set are numbered 21, 22, 23, and 24 respectively and it can be seen that each includes an integral terminal region indicated by the suffix a, the terminal regions protruding into a recessed portion 11a of the housing to define therein four parallel blade terminals. The recess and the four blade terminals define one part of a two part electrical connector, there being a second part, which may be attached to a wiring harness or the like, and which mates with the first part to effect electrical connections to the four terminals.

The conductors 21 and 24 extend along opposite longitudinal sides respectively of the carrier 11 and terminate in parallel, spaced, rectilinear regions extending transversely of the carrier 11 parallel to and adjacent the channel 15. These regions constitute fixed contact tracks which cooperate with the movable contacts 19 of the operating member 16 to provide, in use, an electrical connection to an electric light bulb 16a throughout the range of rectilinear movement of the operating member 16 relative to the housing. It can be seen that the bulb 16a is received within a recess in the operating member 16, and when operative the bulb 16a illuminates a light guide 17a protruding through the portion 17 of the operating member 16.

The conductor 23 extends within the "boundary" defined by the conductors 21 and 24 and terminates in a transversely extending elongate fixed contact parallel to the fixed contacts defined by the conductors 21 and 24.

The fixed contact of the conductor 23 terminates at one end 23b, adjacent but spaced from a further fixed contact region 21b of the conductor 21.

The conductors of the second set are indicated by the reference numerals 25, 26, and 27 respectively and it can be seen that these conductors lie within the "boundary" defined by the conductors 21 and 23 of the first set. The aperture 14a in the carrier 11, within which one of the spigots 14 of the rotor 14 is received, can be seen in Figure 2, and it will be apparent that each of the conductors 25, 26, 27 has an arcuate nature, the curves thereof being circular curves and being centered on the centre of the aperture 14a, and thus upon the axis of rotation of the rotor 13. The conductor 27 is electrically connected to the conductor 22 of the first set and is defined by an electrically conductive area encircling the aperture 14a and having, at its edge presented towards the transverse recess 15, a region 27a having an arcuate boundary centered on the aperture 14a. The conductor 26 has an arcuate region 26a concentric with but spaced from the region 27a, the conductor 26 being electrically connected at one end to the conductor 21 of the first set. The conductor 25 is also arcuate, and is concentric with but spaced from the arcuate region 26a of the region 26, and continuous with the conductor 25, at one end thereof, is an arcuate planar resistor 28. The end of the conductor 25 remote from the resistor 28 is electrically connected to the conductor 26 by way of a second planar resistor 29. The regions of the conductors 21 and 23 immediately adjacent the conductor 25 and the resistor 28 are formed with arcuate edges spaced from but concentric with the conductor 25 and resistor 28.

As mentioned previously the nature of the rotor 13 and the moving contact arrangement carried thereby is not of importance to the present invention. It will be understood however that moving contacts and bridging contacts carried by the rotor 13 can, during angular movement of the rotor 13 relative to the housing, slide along the conductors 25, 26, and 27, the resistor 28, and parts of the conductors 21 and 23 to effect predetermined switching actions, and, in conjunction with the arcuate resistor 28, to define a variable resistor arrangement.

Since all of the conductors 21, 23, 24, 25, 26, and 27 take part in a sliding switching or variable resistor action then it is desirable that their exposed faces, and the surface of the synthetic resin material between the conductors are co-planar so that the operating action is smooth, and abrasion and allied switching problems are minimised. The manufacture of the carrier 11 is as follows.

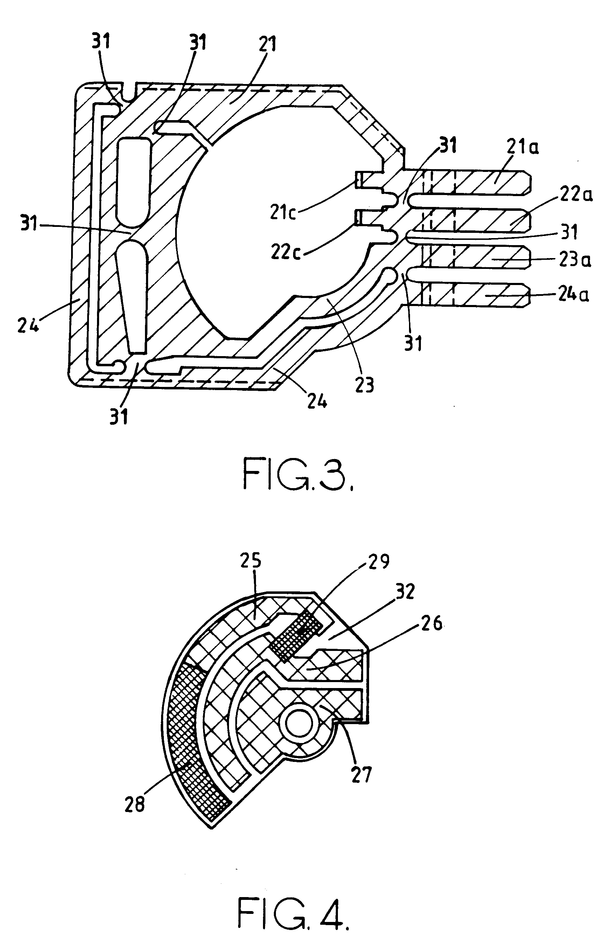

The conductors 21, 22, 23 and 24 are stamped as a single unit known as a fret from a sheet of conductive material, conveniently copper. The fret, which is illustrated in Figure 3 is a self-supporting unit and the relative positions of the four conductors are fixed by integral bridges 31. The conductors 25, 26, and 27 together with the resistor 28 and 29 are carried on a flexible synthetic resin backing sheet 32 (Figure 4) and are formed thereon by known flexible printed circuit techniques. For example, the conductors may be tracks printed on the flexible backing sheet in a conductive ink, with the resistors being printed using a carbon containing conductive ink. As an alternative of course the conductors can be formed by bonding a sheet of conductive foil to the synthetic backing sheet, with unwanted areas of the foil then being etched electrically or chemically from the backing sheet to leave the conductors appropriately positioned and shaped.

The fret defining the conductors 21 - 24 and the flexible printed circuit defining the conductors 25 - 27 and the resistors 28 and 29 are appropriately positioned in a mould which defines the shape of the carrier 11. The fret and the flexible printed circuit are positioned on the wall of the mould which will define the inner surface of the carrier 11 in use with the conductors and resistors of the flexible printed circuit presented to the mould surface. Molten synthetic material conveniently polyetherimide resin is then introduced into the mould and allowed to cool. The hot resin melts, and fuses with, the resin backing sheet of the flexible printed circuit, and of course flows into the interstices of the fret. After cooling the carrier 11 together with the conductors is removed from the mould, the conductors and the resistors being flush with the inner surface of the carrier 11.

Before the carrier 11 is usable in the switch the bridges 31 must be removed, and electrical connections must be firmly established between the conductors 21, 26 and 22, 27. During formation of the fret integral parts 21c, 22c of the conductors 21, 22 are bent to lie at right angles to the plane of the fret so that during the moulding operating forming the carrier 11 the parts 21c, 22c pierce overlying regions of the conductors 26, 27. In order to ensure electrical connection between the conductors at this point a low temperature solder, or more preferably a cold curing conductive epoxy resin material is applied to the points at which the parts 21c and 22c pass through the conductors 26 and 27 respectively. If necessary the resistors 28 and 29 can be trimmed either by mechanical cutting, or laser cutting to achieve predetermined resistance values. The bridges 31 may be removed by a single punch having appropriately positioned cutting areas.

It will be understood that many other electrical circuit elements could be manufactured using the combined fret and flexible printed circuit technique described above, and the invention is not limited to the arrangement illustrated in the drawings. It is not essential that the electric circuit element includes active elements such as resistors, and if desired the conductors could simply provide connection points for the addition of other electronic components such as integrated circuits. However, the flexible printed circuit technique readily accomodates the incorporation of printed active components. It will be understood that other active components could be incorporated if desired, and it is contemplated that these may include diodes and possibly also transistors.

The method of manufacture is advantageous in that the number of manufacturing steps, and thus the tolerance accumulation is minimised. Where the circuit element forms a fixed contact assembly for a sliding action switch then the co-planar arrangement of contacts and intervening electrical insulation material eliminates the possibly of contact bounce, and avoids the need to provide a separately applied infill material between adjacent fixed contacts. Additionally the avoidance of gaps between adajcent contacts ensures that during relative movement of the movable and fixed contact, where necessary, a "contact break" will occur before a subsequent "contact make".

## Claims

1. An electrical circuit element for use in an electrical component including a moulded synthetic resin substrate (11) and two electrical conductor sets (21-24 and 25-27) individually supported on said substrate for engagement in use by a further relatively movable part of said electrical component, the element being characterized by a first of said conductor sets (21-24) including at least one preformed metal strip, the second of said conductor sets (25-27) including at least one printed track, and an upper edge of said at least one strip and said at least one printed track being exposed on said substrate flush with the surface thereof, for engagement in use by a further relatively movable, part of said electrical component.

2. A circuit element as claimed in Claim 1, characterized in that said strip and said track are accessible at one face of the substrate.

3. A circuit element as claimed in Claim 1 or Claim 2, characterized in that said substrate (11) is shaped to form a structural member of the electrical component utilizing the electrical circuit element.

4. A circuit element as claimed in any one of Claims 1 to 3, characterized in that said printed track includes an active electrical component (28).

5. A method of manufacturing an electric circuit element, characterized by comprising the steps of starting with mould means defining the shape of a desired substrate, positioning within said mould means at least one electrical conductor in the form of a preformed metallic strip (21-24), positioning within said mould means, in relation to said strip, a flexible printed circuit including a flexible, electrically insulating backing member (32) with a flexible conductive track (25-27) exposed on one face thereof, the positioning of the strip and the flexible printed circuit in said mould means being such that after moulding said strip and said track will be exposed on the moulded substrate, and, introducing synthetic resin material into said mould means to form said substrate (11).

6. A method as claimed in Claim 5, characterized in that said at least one strip has additional strips integral therewith and the method includes the, subsequent step of removing predetermined interconnections (31) between the strips (21-24) to isolate some or all of the strips electrically from one another.

7. A method as claimed in Claim 5 or Claim 6, characterized in that said flexible printed circuit includes at least one active electrical component (28).

8. An element as claimed in Claim 4 or a method as claimed in Claim 7, characterized in that said active electrical component (28) is an elongate, printed resistor.

## Patentansprüche

1. Elektrisches Schaltelement zur Benutzung in einer elektrischen Komponente mit einem geformten synthetischen Harzsubstrat (11) und zwei elektrischen Leitersätzen (21-24 und 25-27), die einzeln auf dem Substrat getragen sind zum Eingriff bei Benutzung durch ein weiteres relativ bewegbares Teil der elektrischen Komponenten, wobei das Element dadurch gekennzeichnet ist, daß ein erster der Leitersätze (21-24) mindestens einen vorgeformten Metallstreifen aufweist, der zweite der Leitersätze (25-27) mindestens eine gedruckte Spur aufweist und eine obere Kante des mindestens einen Streifen und die mindestens eine gedruckte Spur auf dem Substrat glatt mit dessen Oberfläche offenliegen zum Eingriff bei Benutzung mit einem weiteren relativ bewegbaren Teil der elektrischen Komponente.

2. Schaltelement nach Anspruch 1, dadurch gekennzeichnet, daß der Streifen und die Spur auf einer Fläche des Substrates zugänglich sind.

3. Schaltelement nach Anspruch 1 oder Anspruch 2, dadurch gekennzeichnet, daß das Substrat (11) in der Form eines Strukturteiles der elektrischen Komponente geformt ist, die das elektrische Schaltelement benutzt.

4. Schaltelement nach einem der Ansprüche 1 bis 3, dadurch gekennzeichnet, daß die gedruckte Spur eine aktive elektrische Komponente (28) aufweist.

5. Verfahren zur Herstellung eines elektrischen Schaltelementes, gekennzeichnet durch die Schritte Beginnen mit einem Gießmittel, daß die Form des gewünschten Substrates definiert, Positionieren mindestens eines elektrischen Leiters in der Form eines vorgeformten Metallstreifens (21-24) in dem Gießmittel, Positionieren einer flexiblen gedruckten Schaltung mit einem flexiblen elektrisch isolierenden Rückenteil (32) mit einer flexiblen leitenden Spur (25-27), die auf einer Fläche davon offenliegt, in dem Gießmittel in Beziehung zu dem Streifen, wobei das Positionieren des Streifens und der flexiblen gedruckten Schaltung in der Gießform so ist, daß nach Gießen der Streifen und die Spur auf dem gegossenen Substrat offenliegen, und Einführen von synthetischem Harzmaterial in die Gießform zum Bilden des Substrates (11).

6. Verfahren nach Anspruch 5, dadurch gekennzeichnet, daß der mindestens eine Streifen zusätzliche Streifen daran angeformt aufweist und das Verfahren den folgenden Schritt des Entfernens vorbestimmter Bedingungen (31) zwischen den Streifen (21-27) zum Isolieren von einigen oder aller Streifen elektrisch voneinander aufweist.

7. Verfahren nach Anspruch 5 oder Anspruch 6, dadurch gekennzeichnet, daß die flexible gedruckte Schaltung mindestens eine aktive elektrische Komponente (28) aufweist.

8. Element nach Anspruch 4 oder Verfahren nach Anspruch 7, dadurch gekennzeichnet, daß die aktive elektrische Komponente (28) ein länglicher gedruckter Widerstand ist.

## Revendications

1. Elément de circuit électrique destiné à être utilisé dans un composant électrique incluant un substrat en résine synthétique moulée (11) et deux jeux de conducteurs électriques (21-24 et 25-27) supportés individuellement sur ledit substrat pour pouvoir coopérer en utilisation avec une partie supplémentaire mobile de façon relative dudit composant électrique, l'élément étant caractérisé par le fait qu'un premier desdits jeux de conducteurs (21-24) inclut au moins une bande de métal préformée, que le second desdits jeux de conducteurs (25-27) inclut au moins une piste imprimée et qu'un bord supérieur de ladite au moins une bande et de ladite au moins une piste imprimée est mis à nu sur ledit substrat de manière à affleurer sa surface pour coopérer, en utilisation, avec une partie supplémentaire mobile de façon relative dudit composant électrique.

2. Elément de circuit selon la revendication 1, caractérisé en ce que ladite bande et ladite piste sont accessibles au niveau d'une face du substrat.

3. Elément de circuit selon la revendication 1 ou 2, caractérisé en ce que ledit substrat (11) est conformé de manière à former un élément structurel du composant électrique qui utilise l'élément de circuit électrique.

4. Elément de circuit selon l'une quelconque des revendications 1 à 3, caractérisé en ce que ladite piste imprimée inclut un composant électrique actif (28).

5. Procédé de fabrication d'un élément de circuit électrique, caractérisé en ce qu'il comprend les étapes de, en partant d'un moyen de moule définissant la forme d'un substrat souhaité, positionnement dans ledit moyen de moule d'au moins un conducteur électrique sous la forme d'une bande métallique préformée (21-24), positionnement dans ledit moyen de moule, en relation avec ladite bande, d'un circuit imprimé souple incluant un élément arrière électriquement isolant souple (32) muni d'une piste conductrice souple (25-27) mise à nu sur l'une de ses faces, le positionnement de la bande et du circuit imprimé souple dans ledit moyen de moule étant tel qu'après moulage, ladite bande et ladite piste soient mises à nu sur le substrat moulé, et d'introduction d'un matériau de résine synthétique dans ledit moyen de moule pour former ledit substrat (11).

6. Procédé selon la revendication 5, caractérisé en ce que ladite au moins une bande comporte des bandes supplémentaires d'un seul tenant avec elle et le procédé inclut l'étape qui suit d'enlèvement d'interconnexions prédéterminées (31) entre les bandes (21-24) afin d'isoler électriquement certaines des bandes les unes des autres, voire toutes.

7. Procédé selon la revendication 5 ou 6, caractérisé en ce que ledit circuit imprimé souple inclut au moins un composant électrique actif (28).

8. Elément selon la revendication 4 ou procédé selon la revendication 7, caractérisé en ce que ledit composant électrique actif (28) est une résistance imprimée allongée.
